# EUROPÄISCHE PATENTSCHRIFT

(11) **EP 2 098 802 B1**
(45) Veröffentlichungstag und Bekanntmachung des Hinweises auf die Patenterteilung: **10.05.2017**
(21) Anmeldenummer: 09003131.1
(22) Anmeldetag: 04.03.2009
(51) Int. Cl.: H01L 23/473, H05K 7/20, F24H 9/20, H05K 1/02

(54) **Warmwassergerät mit einem Elektronikkühlrohr**
Water heater with an electronic coolant pipe
Appareil d'eau chaude doté d'un tuyau de refroidissement électronique

(30) Priorität: 04.03.2008 DE 102008012565
(43) Veröffentlichungstag der Anmeldung: 09.09.2009
(73) Patentinhaber: BSH Hausgeräte GmbH, 81739 München (DE)
(72) Erfinder: Bauer, Franz, 83374 Traunwalchen (DE); Englisch, Christian, 83324 Ruhpolding (DE)

(56) Entgegenhaltungen:
- EP-A2- 1 686 329
- DE-A1- 2 400 478
- DE-U1-202004 012 263

## Beschreibung

### Hintergrund der Erfindung

Die vorliegende Erfindung betrifft ein Warmwassergerät zum Bereitstellen von Warmwasser, wobei das Warmwassergerät eine Steuereinrichtung mit einer Vielzahl von elektronischen Bauelementen zum Steuern des Warmwassergeräts und ein Kühlrohr umfasst, welches vom Kaltwasser im Betrieb durchströmt wird.

### Stand der Technik

Warmwassergeräte, insbesondere Durchlauferhitzer, können fest installierbare Heißwassergeräte sein, die bei Bedarf heißes Wasser Erzeugen. Üblicherweise weisen die Warmwassergeräte einen Heizblock auf, der wendelförmig ausgebildet ist. Das Material aus dem vorzugsweise der Heizblock geformt ist, kann druckfester Kunststoff sein. Innerhalb des Heizblocks ist eine Heizeinrichtung angeordnet, welche üblicherweise ein Blankheizdrahtsystem ist. Die Heizwendeln der Heizeinrichtung werden an die Heizkanäle des Heizblocks angepasst, so dass diese vom zu erwärmenden Wasser durchströmt werden können.

Üblicherweise regeln Durchlauferhitzer die gewünschte Temperatur unabhängig von der Zulauftemperatur und dem Durchfluss des zu erwärmenden Wassers. Dazu sind diese Durchlauferhitzer mit elektronischen Schaltelementen (z.B. Triacs oder Thyristoren) ausgestattet. Diese elektronischen Leistungsbauelemente sind thermisch an den Wasserkreislauf (meist Kaltwasserbereich) angekoppelt, um eine Kühlung der aktiven Bauelemente zu erreichen. Dazu wird ein thermischer Übergang vorgesehen, um die Abwärme der Leistungselektronik schnell und effektiv abführen zu können. Hierzu wird gewöhnlich der Wasserkreislauf meist mit einem Formteil (z.B. Vierkantrohr) aus Metall (häufig Kupfer oder Messing) versehen, an welches die elektronischen Schaltelemente angeordnet sind Dokument DE2400478 A1 offenbart den Oberbegriff des Anspruchs 1. Bei all diesen Konstruktionen aus dem Stand der Technik werden die Bauelemente der Leistungselektronik einseitig an einer Kühlvorrichtung angeordnet, so dass diese sich großflächig erstrecken muss, um die Vielzahl der elektronischen Bauelementen thermisch kontaktieren zu können.

### Der Erfindung zugrundeliegende Aufgabe

Der Erfindung liegt die Aufgabe zugrunde, ein verbessertes Warmwassergerät mit einer Steuereinrichtung bereitzustellen, welches eine platzsparende und kosteneffiziente Kühlung der elektronischen Bauelemente der Steuereinrichtung ermöglicht.

### Erfindungsgemäße Lösung

Die Lösung der gestellten Aufgabe gelingt durch ein Warmwassergerät mit den Merkmalen des Anspruchs 1. Vorteilhafte Aus- und Weiterbildungen, welche einzeln oder in Kombination miteinander eingesetzt werden können, sind Gegenstand der abhängigen Ansprüche.

Das erfindungsgemäße Warmwassergerät zum Bereitstellen von Warmwasser umfasst eine Steuereinrichtung mit einer Vielzahl von elektronischen Bauelementen zum Steuern des Warmwassergeräts und ein Kühlrohr, welches vom Kaltwasser im Betrieb durchströmt wird. Das Kühlrohr weist mindestens einen Kühlbereich mit mindestens zwei im Wesentlichen gegenüberliegenden abgeflachten Kühlflächen auf, so dass die elektronischen Bauelemente der Steuereinrichtung beidseitig an den im Wesentlichen gegenüberliegenden Kühlflächen angeordnet sind, um eine Kühlung der elektronischen Bauelemente bereitzustellen.

Gegenüberliegende Kühlflächen bedeutet, dass die Kühlflächen nicht in einer Ebene liegen müssen. So kann beispielsweise eine Anordnung mit im Wesentlichen parallelen Kühlflächen verwendet werden. Auch eine Anordnung, bei welcher die Kühlflächen einen Winkel zueinander aufweisen, kann ebenfalls ausgebildet sein. Auch vorstellbar ist, dass die mindestens zwei Kühlflächen eine gemeinsame Kante oder einen gemeinsamen Bereich aufweisen.Erfindungsgemäß weist die Steuereinrichtung eine Platine mit einer ersten und einer zweiten Platinenseite auf, auf welcher die elektronischen Bauelemente beidseitig angeordnet sind. Durch die beidseitige Bestückung der Platine kann die Steuereinrichtung platzsparend hergestellt werden. Durch diese besondere platzsparende Ausformung können die Außenabmessungen des Warmwassergeräts weiterhin relativ klein gehalten werden.

Erfindungsgemäß verläuft das Kühlrohr über eine ersten und/oder eine zweite Seite der Platine der Steuereinrichtung. Somit kann die Kühlung der gesamten Steuereinrichtung gewährleistet werden. Das Kühlrohr weist mindestens zwei abgeflachte Kühlseiten auf, so dass die elektronischen Bauelemente, wie die Leistungselektronik, beidseitig an diesen abgeflachten Kühlseiten angeordnet werden können. Somit kann die Platine der Steuereinrichtung eine relativ kleine

Fläche aufweisen, da die Kühlung platzsparend beidseitig an dem Kühlrohr bereitgestellt werden kann. Dementsprechend können mit Hilfe nur eines Kühlrohrs mehrere Bauelemente gekühlt werden, ohne dass die platzsparende Bauweise des Warmwassergerätes geändert werden muss. Durch die erfindungsgemäße platzsparende Kühlung der Leistungselektronik kann eine stabile und von Fehlfunktionen freie Funktionsweise der Steuereinrichtung des Warmwassergeräts gewährleistet werden. Ferner durch die beidseitige Anordnung der Bauelemente an das Kühlrohr, wird eine kleinere Strecke im Kaltwasserkreislauf des Warmwassergerätes benötigt, um eine Vielzahl an elektronischen Bauelementen zu kühlen.

### Bevorzugte Ausgestaltung der Erfindung

Es wird bevorzugt, dass die elektronischen Bauelemente der Steuereinrichtung formschlüssig an den im Wesentlichen gegenüberliegenden Kühlflächen angeordnet sind. Durch die formschlüssige Anordnung an den Kühlflächen kann ein guter Wärmeübergang geschaffen werden, und die Platine der Steuereinrichtung muss nicht großflächig ausfallen, da die Bauelemente auf der Platine eng bzw. platzsparend bestückt werden können. Vorteilhafterweise werden die elektronischen Bauelemente mittels Kühlpaste an den Kühlflächen angeordnet. Dies verbessert den Wärmeübergang zwischen Leistungselektronik und Kühlrohr, um einen fehlerfreien Betrieb der elektronischen Steuereinrichtung zu gewährleisten.

Gemäß einer möglichen Ausführungsform der vorliegenden Erfindung ist das Kühlrohr ein metallisches Kühlrohr und als Vierkantrohr ausgebildet. Durch die Verwendung von metallischen Kühlrohren kann eine effiziente und effektive Wärmeableitung realisiert werden. Das metallische Vierkantrohr ist preisgünstig und weist alle erfindungsgemäßen Vorteile auf, nämlich mindestens zwei gegenüberliegende Kühlflächen, an welche die Bauelemente angeordnet werden können. Bevorzugt können Dreikant- oder Mehrkantröhre verwendet werden, da diese ebenfalls unterschiedliche Kühlflächen aufweisen.

Zweckmäßiger Weise umfassen die elektronischen Bauelemente Triacs und/oder Thyristoren. Somit kann die Heizwirkung des Warmwassergeräts gesteuert werden.

In einer bevorzugten Ausführungsform der vorliegenden Erfindung kann das Kühlrohr mittels eines Walzverfahren und/oder Pressverfahren hergestellt sein. Durch die Wahl dieser Verfahren können besonders vorteilhaft Kühlflächen am Kühlrohr realisiert werden, um eine formschlüssige Anbindung der elektronischen Bauelemente bereitzustellen.

Durch die Pressung des Kühlrohrs wird weiterhin erreicht, dass die Querschnittsfläche, durch welche das Wasser durchfließt, eingeengt ist. Dadurch steigt die Strömungsgeschwindigkeit im Kühlrohr und der Wärmeübergang zum Wasser wird verbessert.

Insbesondere ist das Warmwassergerät ein Durchlauferhitzer. Da Durchlauferhitzer elektronisch geregelt sind, kann die erfindungsgemäße Kühlung von besonderem Vorteil sein.

In einer vorteilhaften Weise ist das Kühlrohr derart angeordnet, dass eine Abwärme der elektronischen Bauelemente zum Vorheizen des Kaltwassers, welches im Warmwassergerät erwärmt werden soll, verwendbar ist. Durch diese Anordnung kann die Abwärme wirtschaftlich verwendet werden, da die Heizeinrichtung des Warmwassergerätes effektiver arbeiten kann.

### Kurzbeschreibung der Zeichnungen

Weitere vorteilhafte Ausgestaltungen werden nachfolgend an Hand von in der Zeichnung dargestellten Ausführungsbeispielen, auf welche die Erfindung jedoch nicht beschränkt ist, näher beschrieben.

Es zeigen schematisch:
- Fig. 1: eine perspektivische Seitenansicht der Steuereinrichtung;
- Fig. 2: einen Draufsicht auf die Steuereinrichtung eines Warmwassergeräts gemäß der vorliegenden Erfindung; und
- Fig. 3: unterschiedliche Querschnitte eines Kühlrohrs gemäß der vorliegenden Erfindung.

### Ausführliche Beschreibung anhand eines Ausführungsbeispiels

Bei der nachfolgenden Beschreibung der vorliegenden Erfindung bezeichnen gleiche Bezugszeichen gleiche oder vergleichbare Komponenten.

Die in der vorstehenden Beschreibung, den Ansprüchen und den Zeichnungen offenbarten Merkmale können sowohl einzeln als auch in beliebiger Kombination für die Verwirklichung der Erfindung in ihren verschiedenen Ausgestaltungen von Bedeutung sein.

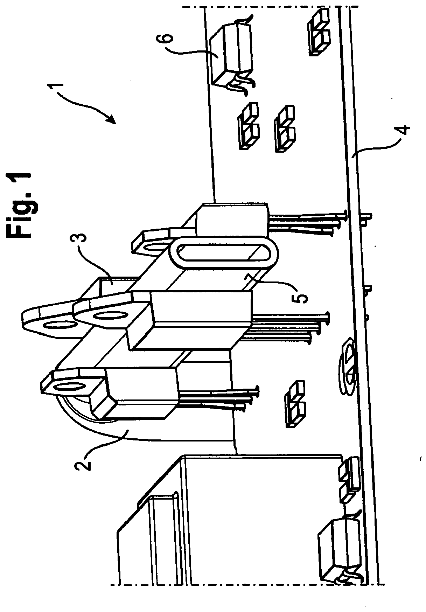

Fig. 1 zeigt eine Steuereinrichtung 1 eines Warmwassergeräts, insbesondere eines Durchlauferhitzers, mit einem metallischen Kühlrohr 2 gemäß der vorliegenden Erfindung. Die Steuereinrichtung 1 wird zusammen mit einem Heizblock oder einem Warmwasserspeicher in einem Gehäuse untergebracht. Prinzipiell wird das Warmwassergerät an den Kaltwasserhausanschluss angeschlossen, und an einer Auslaufstelle kann heißes bzw. warmes Wasser gezapft werden.

Die Steuereinrichtung 1 weist eine Platine 4 auf, auf welcher eine Vielzahl von Leiterbahnen ausgebildet sind, welche alle elektronischen Bauelemente 3 und 6 elektrisch untereinander verbinden. Die Steuereinrichtung 1 umfasst auch ein Netzteil 6 welches den notwendigen Strom für die Steuereinrichtung und für die weiteren elektronischen Bauelemente 6 bereitstellt. Da die Steuereinrichtung 1 die Heizeinrichtung (nicht gezeigt) des Warmwassergeräts steuert, muss diese eine Vielzahl von leistungsstarken Bauelementen 3 aufweisen, welche die Leistungselektronik 3 der Steuereinrichtung ausbilden. Diese werden in der Regel während des Betriebes sehr heiß und müssen, um eine fehlerfreie Funktionsweise der Steuereinrichtung zu gewährleisten, gekühlt werden. Dies geschieht erfindungsgemäß mit Hilfe des Kühlrohrs 2, welches beispielsweise am Kaltwasseranschluss angeschlossen wird. Das andere Ende des Kühlrohrs verläuft beispielsweise in den Heizblock des Warmwassergerätes, in welchem nachträglich das kalte Wasser auf einer gewünschten Temperatur erhitzt wird.

Das Kühlrohr 2 kann beispielsweise in einem Walz- oder Pressverfahren hergestellt worden sein und weist gemäß einer Ausführungsform zwei gegenüberliegende Flächen 5 und 7 auf, welche in einem abgeflachten Bereich des Kühlrohrs ausgebildet sind. Dieser Bereich entspricht dem Kühlbereich des Kühlrohrs gemäß dieser Ausführungsform der vorliegenden Erfindung. Die elektronischen Bauelemente 3 der Leistungselektronik (Triacs und/oder Thyristoren) werden beidseitig und formschlüssig an die Kühlflächen 5 und 7 angeordnet, um somit eine effiziente Absorption der Abwärme in das Kühlwasser mit Hilfe des Kühlrohrs 2 zu gewährleisten. Gemäß dieser Ausführungsform wist das Kühlrohr einen zusammengepressten Querschnitt auf, durch welchen das Kühlwasser durch den höher erzielten Druck schneller durchfließen kann. Somit kann die Wärme besser abtransportiert und die Leistungselektronik 3 besser gekühlt werden. Es sind auch andere Querschnitte des Kühlrohrs vorstellbar, jedoch sollten diese Formen ebenfalls mindestens zwei Kühlflächen 5 und 7 aufweisen, damit die elektronischen Bauelemente auf zwei Kühlflächen 5, 7 beidseitig und platzsparend angeordnet sein können. Durch diese vorteilhafte Anordnung der Leistungselektronik 3 auf das Kühlrohr 2 kann der Platzbedarf auf der Platine 4 minimiert werden.

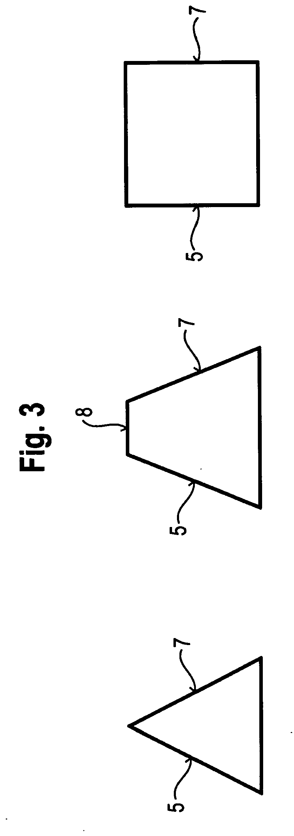

Ferner kann zusätzliche Leistungselektronik (nicht dargestellt) auch auf einer Unterseite der Platine 4 angeordnet werden. In diesem Fall soll das Kühlrohr beispielweise beide Seiten der Platine 4 überqueren, damit alle Bauelemente der Leistungselektronik gekühlt werden können. Auch denkbar ist, dass der Querschnitt des Kühlrohrs andere Formen aufweisen kann, wie beispielhaft in der Fig. 3 in einem Querschnitt gezeigt ist.

Die gegenüberliegenden Kühlflächen 5 und 7 des Kühlbereichs sind gemäß dieser Ausführungsform parallel dargestellt, jedoch ist es denkbar, dass die durch die Kühlflächen 5 und 7 definierten Ebenen, beispielsweise einen anderen Winkel zueinander aufweisen. Das somit definierte Kühlrohr weist ebenfalls mindestens zwei Kühlflächen 5 und 7, auf welchen platzsparend die Leistungsbauteile 3 der Leistungselektronik angeordnet werden können.

Um einen effizienten Wärmeübergang zwischen Leistungsbauteile 3 und Kühlrohr herzustellen, kann beispielsweise Kühlpaste zur Befestigung an das Kühlrohr verwendet werden.

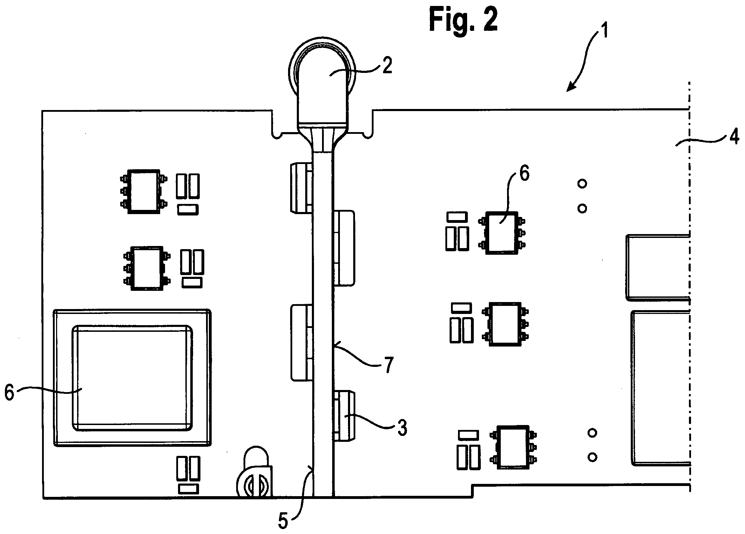

Fig. 2 zeigt eine Steuereinrichtung eines Warmwassergeräts in einer Draufsicht. Die Platine 4 weist eine Vielzahl von elektronischen Bauelementen 3 und 6 welche mit Leiterbahnen miteinander im elektrischen Kotakt stehen. Die Steuereinrichtung 1 steuert beispielsweise einen Durchlauferhitzer (nicht abgebildet), der wiederum erwärmtes Wasser bereitstellt. Wie oben erwähnt müssen die aktiven Bauelemente der Leistungselektronik 3 gekühlt werden, um einen sicheren und fehlerfreien Betrieb des Warmwassergeräts bzw. Durchlauferhitzers zu gewährleisten.

Dazu wird gemäß dieser Ausführungsform ein Kühlrohr 2 vorgesehen, welche die Platine 4 einseitig überquert und an den aktiven Bauteile 3 formschlüssig angeordnet ist. So kann die Abwärme an das Wasser, welches das Kühlrohr 2 durchströmt, abgeführt werden. In diesem Ausführungsbeispiel werden nicht alle Bauteile der Steuerelektronik direkt gekühlt, es ist jedoch vorstellbar, dass das Kühlrohr mehrere male die Platine 4 überqueren kann, um die Anzahl der gekühlten elektronischen Elemente zu erhöhen.

Auch dieses Kühlrohr 2 weist im Wesentlichen zwei parallel verlaufenden Kühlflächen 5 und 7, an welchen sich beispielsweise die Triacs 3 thermisch zur Wärmeableitung anschließen. Somit kann die Anzahl der zu kühlenden Elemente erhöht werden, da bei einer einseitigen Anordnung der Platz am Kühlrohr durch die physikalische Abmessung begrenzt ist.

Das Kühlrohr 2 wird bevorzugt am Kaltwasseranschluss des Warmwassergeräts angebracht, so dass das zu erwärmende Wasser vorerst den Kühlbereich durchströmen muss. Durch die Abwärme der elektronischen Leistungsbauteile 3 wird das Kühlwasser vorgeheizt, so dass die Heizeinrichtung innerhalb des Warmwassergeräts mit einem höheren Wirkungsgrad und energieeffizienter betrieben werden kann.

Schließlich zeigt Fig. 3 einige mögliche Querschnitte des Kühlrohrs 2. Die vorliegende Erfindung ist jedoch nicht auf diese Ausführungsbeispiele eingeschränkt. Im Gegensatz zu den in den Figuren 1 und 2 gepressten Kühlrohre 2, zeigt Fig. 3 einige Beispiele eines Vier- bzw. Dreikantrohres, welche durch andere Verfahren hergestellt werden können. Auch diese Kühlrohre weisen mindestens zwei Kühlflächen 5 und 7, welche nicht immer parallel Verlaufen. Auch hier können die Bauelemente der Leistungselektronik 3 beidseitig und formschlüssig angeordnet werden, um einen platzsparenden Abtransport der Wärme zu gewährleisten. Es ist denkbar, dass das Kühlrohr 2 beispielsweise einen Übergangsbereich bzw. Verbindungsbereich 8 aufweist, auf welchem weitere Bauelemente zwecks Kühlung angeordnet werden können.

### Bezugszeichenliste

- 1: Steuereinrichtung eines Warmwassergeräts
- 2: Kühlrohr
- 3: Leistungselektronik bzw. Elektronikbauelemente
- 4: Platine
- 5: Erste Kühlseite
- 6: Weitere Elektronikbauelemente
- 7: Zweite Kühlseite
- 8: Verbindungsbereich

## Patentansprüche

1. Warmwassergerät zum Bereitstellen von Warmwasser, umfassend eine Steuereinrichtung (1) mit einer Vielzahl von elektronischen Bauelementen (3) zum Steuern des Warmwassergeräts und ein Kühlrohr (2), welches vom Kaltwasser im Betrieb durchströmt wird, **dadurch gekennzeichnet, dass** das Kühlrohr (2) mindestens einen Kühlbereich (5, 7) mit mindestens zwei im Wesentlichen gegenüberliegenden abgeflachten Kühlflächen (5, 7) aufweist, so dass die elektronischen Bauelemente (3) der Steuereinrichtung (1) beidseitig an den im Wesentlichen gegenüberliegenden Kühlflächen (5, 7) angeordnet sind, um eine Kühlung der elektronischen Bauelemente (3) bereitzustellen, **dadurch gekennzeichnet, dass** die Steuereinrichtung (1) eine Platine (4) mit einer ersten und einer zweiten Platinenseite aufweist, auf welcher die elektronischen Bauelemente (3) beidseitig angeordnet sind, und dass das Kühlrohr (2) über eine ersten und/oder eine zweite Seite der Platine der Steuereinrichtung (1) verläuft.

2. Warmwassergerät nach Anspruch 1, **dadurch gekennzeichnet, dass** die elektronischen Bauelemente (3) der Steuereinrichtung (1) formschlüssig an den im Wesentlichen gegenüberliegenden Kühlflächen (5, 7) angeordnet sind.

3. Warmwassergerät nach Anspruch 1 oder 2, **dadurch gekennzeichnet, dass** die elektronischen Bauelemente (3) mittels Kühlpaste an den Kühlflächen (5, 7) angeordnet sind.

4. Warmwassergerät nach einem der vorhergehenden Ansprüche, **dadurch gekennzeichnet, dass** das Kühlrohr (2) ein metallisches Kühlrohr ist und als Vierkantrohr ausgebildet ist.

5. Warmwassergerät nach einem der vorhergehenden Ansprüche, **dadurch gekennzeichnet, dass** die elektronischen Bauelemente (3) Triacs und/oder Thyristoren umfassen.

6. Warmwassergerät nach einem der vorhergehenden Ansprüche, **dadurch gekennzeichnet, dass** das Kühlrohr (2) mittels eines Walzverfahren und/oder Pressverfahren hergestellt ist.

7. Warmwassergerät nach einem der vorhergehenden Ansprüche, **dadurch gekennzeichnet, dass** das Warmwassergerät ein Durchlauferhitzer ist.

8. Warmwassergerät nach einem der vorhergehenden Ansprüche, **dadurch gekennzeichnet, dass** das Kühlrohr (2) derart angeordnet ist, dass eine Abwärme der elektronischen Bauelemente (3) zum Vorheizen des Kaltwassers, welches im Warmwassergerät erwärmt werden soll, verwendbar ist.

## Claims

1. Water heater for the provision of hot water, comprising a control device (1) having a plurality of electronic components (3) for controlling the water heater and a coolant pipe (2), through which cold water flows during operation, **characterised in that** the coolant pipe (2) has at least one cooling region (5, 7) having at least two essentially opposing flattened cooling surfaces (5, 7), such that the electronic components (3) of the control device (1) are arranged on both sides on the essentially opposing cooling surfaces (5, 7), in order to cool the electronic components (3), **characterised in that** the control device (1) has a circuit board (4) with a first and a second circuit board side, on which the electronic components (3) are arranged on both sides, and that the coolant pipe (2) runs via a first and/or a second side of the circuit board of the control device (1).

2. Water heater according to claim 1, **characterised in that** the electronic components (3) of the control device (1) are arranged in a form-fit manner on the essentially opposing cooling surfaces (5, 7).

3. Water heater according to claim 1 or 2, **characterised in that** the electronic components (3) are arranged on the cooling surfaces (5, 7) by means of thermal paste.

4. Water heater according to one of the preceding claims, **characterised in that** the coolant pipe (2) is a metal coolant pipe and is designed as a square pipe.

5. Water heater according to one of the preceding claims, **characterised in that** the electronic components (3) comprise triacs and/or thyristors.

6. Water heater according to one of the preceding claims, **characterised in that** the coolant pipe (2) is manufactured by means of a rolling method and/or by press-moulding methods.

7. Water heater according to one of the preceding claims, **characterised in that** the water heater is an instantaneous water heater.

8. Water heater according to one of the preceding claims, **characterised in that** the coolant pipe (2) is arranged such that waste heat from the electronic components (3) can be used to pre-heat the cold water which is to be heated in the water heater.

## Revendications

1. Appareil producteur d'eau chaude destiné à fournir de l'eau chaude, comprenant un dispositif de commande (1) avec une pluralité de composants électroniques (3) pour commander ledit appareil et un tube de refroidissement (2) traversé en fonctionnement par l'eau froide, **caractérisé en ce que** le tube de refroidissement (2) comporte au moins une zone de refroidissement (5, 7) avec au moins deux surfaces de refroidissement aplaties (5, 7) sensiblement opposées, de telle sorte que les composants électroniques (3) du dispositif de commande (1) sont montés des deux côtés sur les surfaces de refroidissement (5, 7) sensiblement opposées afin de fournir un refroidissement des composants électroniques (3), **caractérisé en ce que** le dispositif de commande (1) comporte une platine (4) avec un premier et un deuxième côté de platine, sur laquelle les composants électroniques (3) sont montés des deux côtés, et **en ce que** le tube de refroidissement (2) s'étend sur un premier et/ou un deuxième côté de la platine du dispositif de commande (1).

2. Appareil producteur d'eau chaude selon la revendication 1, **caractérisé en ce que** les composants électroniques (3) du dispositif de commande (1) sont montés par complémentarité de forme sur les surfaces de refroidissement (5, 7) sensiblement opposées.

3. Appareil producteur d'eau chaude selon la revendication 1 ou 2, **caractérisé en ce que** les composants électroniques (3) sont montés au moyen d'une pâte de refroidissement sur les surfaces de refroidissement (5, 7).

4. Appareil producteur d'eau chaude selon l'une des revendications précédentes, **caractérisé en ce que** le tube de refroidissement (2) est un tube de refroidissement métallique et se présente sous forme de tube carré.

5. Appareil producteur d'eau chaude selon l'une des revendications précédentes, **caractérisé en ce que** les composants électroniques (3) comprennent des triacs et/ou des thyristors.

6. Appareil producteur d'eau chaude selon l'une des revendications précédentes, **caractérisé en ce que** le tube de refroidissement (2) est réalisé au moyen d'un procédé de laminage et/ou de filage.

7. Appareil producteur d'eau chaude selon l'une des revendications précédentes, **caractérisé en ce que** l'appareil producteur d'eau chaude est un chauffe-eau instantané.

8. Appareil producteur d'eau chaude selon l'une des revendications précédentes, **caractérisé en ce que** le tube de refroidissement (2) est monté de manière à pouvoir utiliser la chaleur dissipée des composants électroniques (3) pour préchauffer l'eau froide devant être chauffée dans l'appareil producteur d'eau chaude.
